(19) **Europäisches Patentamt**

**European Patent Office**

**Office européen des brevets**

(11) **EP 1 195 987 B1**

(12) **EUROPEAN PATENT SPECIFICATION**

(45) Date of publication and mention
of the grant of the patent:
**31.03.2004 Bulletin 2004/14**

(51) Int Cl.⁷: **H04N 5/217**, H04N 3/15

(21) Application number: **01121187.7**

(22) Date of filing: **04.09.2001**

(54) **Improved image sensor reset circuit for reducing image lag**

Verbesserte Bildsensor-Rücksetzschaltung zur Reduzierung des Bildnachleuchtens

Circuit de réinitialisation amélioré pour capteurs d'image pour réduire le retard d'image

(84) Designated Contracting States:
**DE FR GB**

(30) Priority: **03.10.2000 US 678951**

(43) Date of publication of application:
**10.04.2002 Bulletin 2002/15**

(73) Proprietor: **Agilent Technologies, Inc. (a Delaware corporation)**
**Palo Alto, CA 94303 (US)**

(72) Inventors:
 • **Haddad, Homayoon**
  **Corvallis OR 97330 (US)**
 • **Borg, Matthew M.**
  **Corvallis, OR 97330 (US)**
 • **Mentzer, Ray A.**
  **Corvallis, OR 97333 (US)**
 • **Gibson, Jonathan S.**
  **Aurora, OR 97002 (US)**
 • **Kopley, Thomas Edward**
  **Menlo Park, California 94025 (US)**
 • **Theil, Jeremy A.**
  **Mountain View, California 94040 (US)**
 • **Budrys, Audrius J.**
  **Mountain View, California 94043 (US)**

(74) Representative: **Schoppe, Fritz, Dipl.-Ing.**
**Patentanwälte Schoppe, Zimmermann, Stöckeler & Zinkler,**
**Postfach 246**
**82043 Pullach bei München (DE)**

(56) References cited:
 **EP-A- 1 143 709          WO-A-99/53683**
 **WO-A-99/66712**

 • **AFLATOONI K, ET AL.: "Dependence of image transient behaviour on operating parameters ..." MATERIALS RESEARCH SOCIETY SYMP. PROC. , vol. 557, 5 April 1999 (1999-04-05), pages 827-832, XP000895256 usa**

**Description**

Field of the Invention

The present invention is directed towards the field of imaging electronics particularly towards minimizing residual charge in amorphous silicon pixel arrays.

BACKGROUND

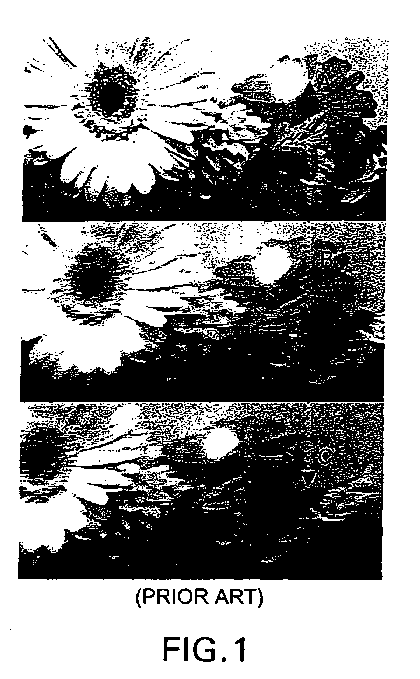

Amorphous silicon (a-Si) has been used to build three dimension pixels for optical sensors. This material enables CMOS sensors with greater than 90% fill factor. For high dynamic range scenes involving motion, image lag results in the smearing of bright spot into dark spot. Figure 1 shows a scene where a bright spot has moved from A to C, leaving a trace of residual light behind. Image lag is maximized when a scene illumination is quickly changed from bright to dark.

An active pixel array (APS) sensor of the prior art comprises a first-n-channel transistor, the gate of which receives the voltage controller output and the drain of which is connected to $V_{DD}$. An a-Si diode is reverse-biased between the source of the first n-channel transistor and ground. For a second n-channel transistor, the gate is connected to the source of the first n-channel transistor and the drain is connected to $V_{DD}$. For a third n-channel transistor, the drain is connected to the source of the second n-channel transistor, the gate receives ROW data, and the source is connected to the output $V_{OUT}$.

In the article of Aflatooni K., et. al.: "Dependence of image transient behaviour on operating parameters of amorphous silicon image sensors" in Materials Research Society Symp. Proc., vol. 557, April 5, 1999, pages 827 to 832, the transient behaviour in imaging characteristics using amorphous silicon X-ray image sensors is described. The results of a systematic study on the image lag and its dependence on various operating conditions of the image sensors, such as applied bias, light intensity, frame time, and applied gate voltage is described. The charge retention in the intrinsic region of the photodiode is found to be an important source of the image lag and it is correlated to the forward transient characteristics of the diode. This correlation can be explained by the common underlying mechanism leading to depletion region formation and charge transport through the diode. The time dependent decay of the time lag, originated mainly from charge retention in the diode, presents a power-low time dependence, which is consistent with the release of trapped charges from a continuous distribution of defect states.

It is the object underlying the present invention to provide an improved imaging system enabling for minimizing time lag upon recording a scene.

This object is achieved by an imaging system according to claim 1.

SUMMARY

The present invention is an imaging system that includes sensor logic, an image processor receiving and transmitting data to the sensor logic, a reverse bias controller, and a pixel array having image lag. The reverse bias controller effects the image lag.

In one embodiment, the image lag is minimized by eliminating or reducing the charge contributed during the scanning period and maintain a reverse voltage at the diode node. These actions minimize the trapping of electrons and holes at the defect sites. The reverse bias condition at int2 lowers the charge capture rate at defect sites by pulling the charge to positive and negative terminals immediately after illumination induced electron and hole generation. The reverse bias controller includes a PRESET line. The PRESET line controls the int2 reverse bias condition. For a first n-channel field effect transistor (n-FET), the drain is connected to the PRESET line, the gate is connected to a RESET line. An a-Si diode is reverse biased between the source of the first nFET and ground. For a second n-FET, the drain is connected to $V_{DD}$, the gate is connected to the source of the first n-FET. For a third n-FET, the drain is connected to the source of the second n-FET, the gate is connected to the ROW DECODER within the image processor, and the source is PIXEL out.

The useful range of the pixel is from $V_{dd}$-$V_t$ to GND+$1V_t$. A voltage clamp limits the integration level at int1 to GND+$1V_t$ by placing a nominally $2V_t$ at the gate of the reset transistor during int1. In another embodiment, the reverse bias controller acts as a clamping circuit to create a programmable voltage of $3 V_t$ +/- $V_t$. A higher clamp voltage will limit the dynamic range, while a lower level allows the diode to integrate to voltages as low as ½ $V_t$. The clamp voltage can be adjusted according to the signal path gain so as to maximize reverse bias on the PD node while not limiting the dynamic range. This clamp circuit limits the possibility of forward biasing the a-Si diode due to very high illuminations during int1 and has a programmable feature to optimize the reverse bias condition level.

BRIEF DESCRIPTION OF THE DRAWINGS

Figure 1 illustrates a scene where a bright spot occurs using pixel array of the prior art.
Figure 2 illustrates an amorphous silicon pixel (diode) of the prior art.
Figure 3 illustrates a functional block diagram for a pixel array controller of the present invention.
Figure 4 illustrates a VGA array where INT2>INT1 in a very bright lighting scene.
Figure 5 illustrates a circuit schematic diagram for a pixel sensor controlled by the voltage controller shown in Figure 3.
Figure 6 illustrates a functional block diagram for the voltage controller 16 shown in Figure 3.
Figure 7 shows a schematic diagram embodiment for the embodiment shown in Figure 3.

DETAILED DESCRIPTION OF THE DRAWINGS

In the present invention, every pixel is conditioned to minimize amorphous silicon image lag.

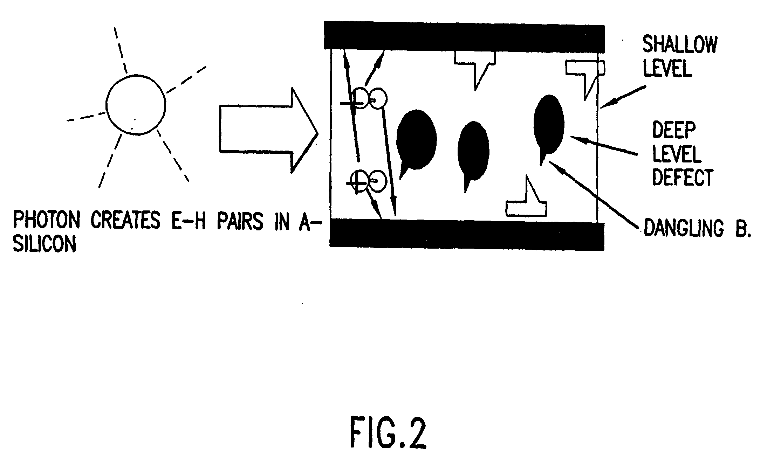

Figure 2 illustrates a PIN-diode operation where image lag is due to the presence of crystal imperfections in amorphous silicon (a-Si) material structure. When a photon hits a-Si material, electron-hole pairs are generated. Electrons are attracted to the positive terminal and holes to the negative terminal. Due to imperfections in the a-Si material, e.g. deep and shallow level defects, some of these carriers are captured at the defect sites and not released until later. Depending on temperature and electric field, it may take up to 100 seconds for very deep level defects to release captured charge.

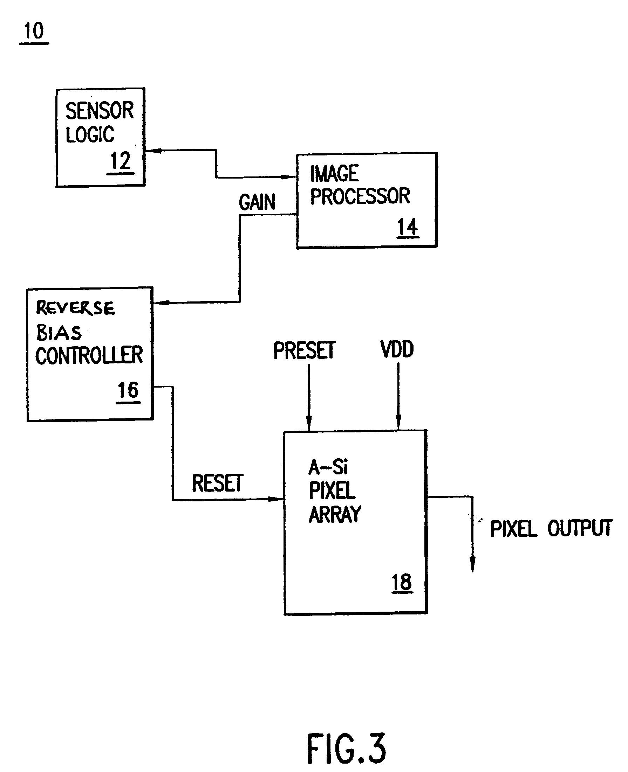

Figure 3 illustrates a functional block diagram for a pixel array controller 10 of the present invention. Sensor logic 12 is connected to an image processor 14. The image processor 14 transmits a gain signal to a reverse bias controller 16. The reverse bias controller 16 emits a RESET signal to an a-Si pixel array 18. The pixel array 18 is further connected to a power supply VDD and a preset voltage selector PRESET.

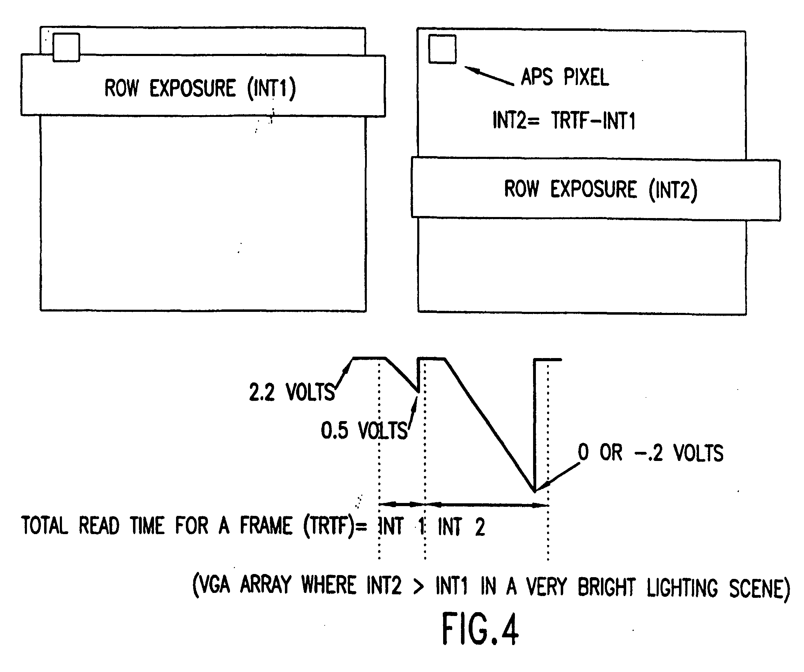

Image sensors are made by integrating a plurality of single pixels into an array 18. Common Interchange Formant (CIF) format is 352x288 pixels while V Graphic Array (VGA) format is 640x480 pixels. Figure 4 shows a VGA array with two integration times: Int1 and Int2. Int1 is the time required to sense a scene. Int2 is the time between read operations of a single pixel. Alternatively, Int2 is just the wait time to maintain an optimum voltage level and pixel cycling. Int2 is expressed as follows:

$$Int2 = [Total\_frame\_read\_time]-Int1 \qquad \text{Equation 1}$$

When the duration of Int2 is twice that of Int1, the amount of discharge on the photodiode (PD) node during Int2 is twice as much as Inti.

If Int2 is twice the duration of Int1, the amount of discharge on the PD node during int2 will be twice as much as during int1 under the same illumination. As a result of the charge accumulation, the voltage level at PD node can forward bias the a-Si diode. This corresponds to a high charge capture rate at the deep defect sites.

Image lag is the main barrier to acceptance of a-Si in CMOS sensor technology. There are several causes image lag including the material deposition techniques, deep and shallow level defects, and circuit interactions.

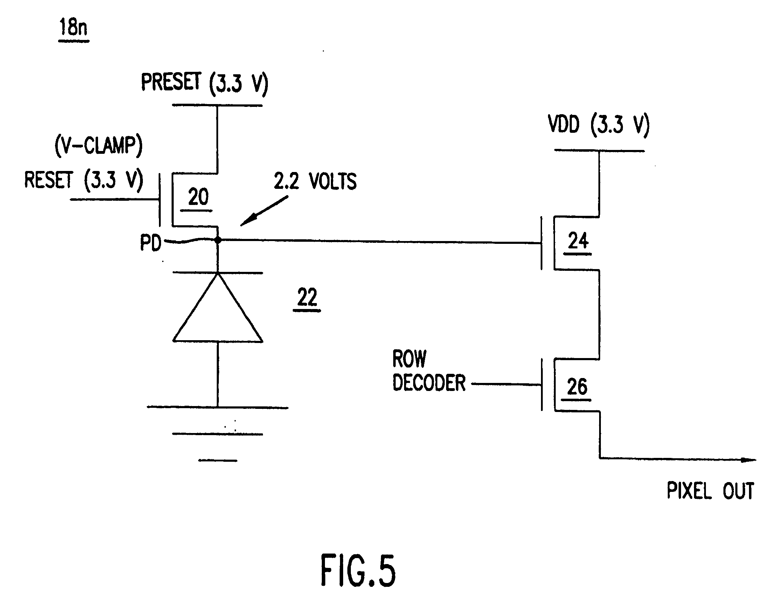

In the present invention, one embodiment to minimize lag is to eliminate the charge contributed during the scanning period and maintaining an optimum reverse voltage at the photodiode node PD (see Fig. 5). These actions minimize the trapping of electrons and holes at the defect sites. The reverse bias condition at int2 lowers the charge capture rate at defect sites by pulling the charge to positive and negative terminals immediately after illumination induced electron and hole generation.

One embodiment of the pixel circuit $18_n$ of the present invention, shown in Figure 5, includes a PRESET line. The PRESET line controls the int2 reverse bias condition. For a first n-channel field effect transistor (n-FET) 20, the drain is connected to the PRESET line, the gate is connected to a RESET line. An a-Si diode 22 is reverse biased between the source of the first nFET 20 and ground. For a second n-FET 24, the drain is connected to $V_{DD}$, the gate is connected to the source of the first n-FET 20. For a third n-FET 26, the drain is connected to the source of the second n-FET 24, the gate is connected to the ROW DECODER within the image processor, and the source is PIXEL out. In this embodiment, voltage controller 16 provides the RESET signal.

Initially, the reset line is set to 3.3 V. This creates a voltage on the PD node of ~2.2V. The PD node is positively charged. When the scene is illuminated, the electron moves to the source of the RESET transistor and lowers the PD node from the RESET value of ~2.2V to close to oV. The clamp voltage is applied to the gate of the RESET transistor. Due to the subthreshold behavior of the RESET transistor, the PD node will be clamped to the same voltage as the clamp voltage. This is due to a fight at the PD node between photon generated current and RESET transistor subthreshold current.

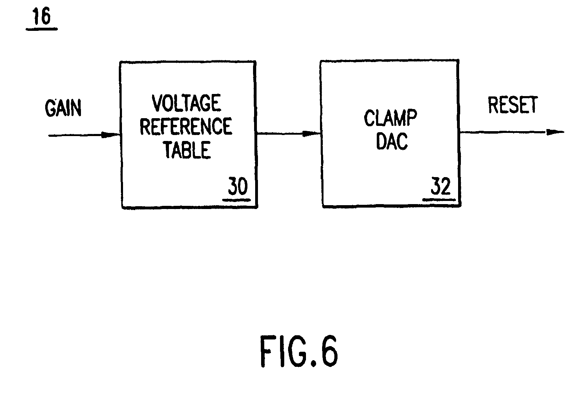

The useful range of the pixel is from $V_{dd}-V_t$ to GND+1$V_t$. A voltage clamp limits the integration level at int1 to GND+1$V_t$ by placing a nominally 2$V_t$ at the gate of the reset transistor during int1. In an alternate embodiment of the present invention, shown in Figure 6, the reverse bias controller 16 includes a voltage reference table 30 and a clamp circuit 32.

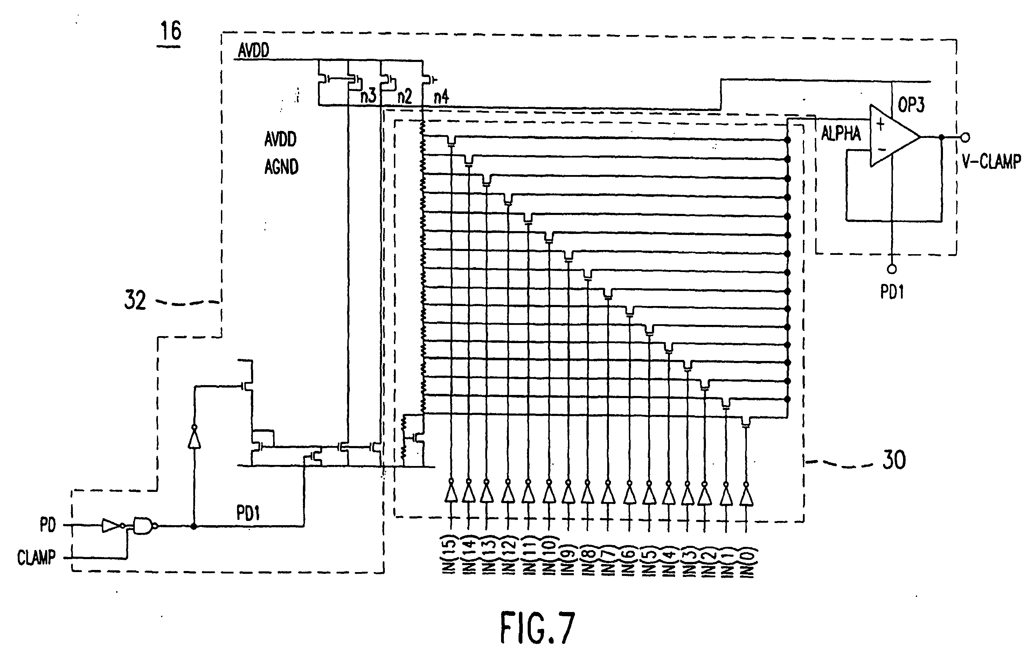

Figure 7 shows a schematic diagram corresponding to the voltage controller 16 shown in Figure 6. While voltage reference table 30 is implemented as a circuit, the concept is easily implemented in software via a lookup table. Clamp circuit 32 is a clamp digital-analog converter (DAC). This circuit creates a programmable voltage of 3 $V_t$ +/- $V_t$. A higher clamp voltage will limit the dynamic range, while a lower level allows the diode to integrate to voltages as low as ½ $V_t$. The clamp voltage can be adjusted according to the signal path gain so as to maximize reverse bias on the PD node while not limiting the dynamic range. This clamp circuit limits the possibility of forward biasing the a-Si diode due to very high illuminations during int1 and has a programmable feature to optimize the reverse bias condition level.

**Claims**

1. An imaging system for minimizing image lag, the imaging system providing a pixel output signal (PIXEL OUT), and the imaging system comprising:

   sensor logic (12);

   an image processor (14) connected to the sensor logic (12) and generating a gain signal (GAIN) on the basis of data received from the sensor logic (12);

   a pixel array (18) having a plurality of pixel circuits (18n), each pixel circuit (18n) comprising a photodetector (22) connected and reverse biased between a power supply (PRESET) and ground and a pixel output connected to a photodetector node (PD) arranged between the power supply (PRESET) and the photodetector (22); and

   a reverse bias controller (16) connected between the image processor (14) and the pixel array (18) and receiving the gain signal (GAIN) from the image processor (14), the reverse bias controller (16) generating a bias control signal (RESET) in response to the gain signal (GAIN) received from the image processor (14), and the reverse bias controller (16) providing the bias control signal (RESET) to the photoconductor node (PD) of the pixel circuit (18n) of the pixel array (18), thereby maintaining the reverse bias condition of the photodetector (22).

2. The imaging system, as defined in claim 1, wherein the pixel array (18) is made from amorphous silicon.

3. The imaging system, as defined in claim 1 or 2, wherein the reverse bias controller (16) includes:

   a voltage reference table (30), receiving the gain signal (GAIN) and generating a voltage output; and

   voltage clamp digital-analog converter (32), receiving the voltage output from the voltage reference table (30) and generating the bias control signal (RESET).

4. The imaging system, as defined in one of claims 1 to 3, wherein each pixel circuit (18n) of the pixel array (18) comprises
   a first n-channel field effect transistor (20) having a drain receiving a supply signal (PRESET) and a gate receiving the bias control signal (RESET);
   a second n-channel field effect transistor (24) having a drain connected to a power supply (VDD) and a gate connected to the source of the first n-channel field effect transistor (20); and
   a third n-channel field effect transistor (26) having a drain connected to the source of the second n-channel field effect transistor (24), a gate connected to the image processor, and a source providing the pixel output signal (PIXEL OUT);
   wherein the photodetector (22) is an amorphous silicon diode, connected between the source of the first n-channel field effect transistor (20) and ground, the photodetector node (PD) being between the source of the first n-channel field effect transistor (20) and the amorphous silicon diode (22).

**Patentansprüche**

1. Ein Bilderzeugungssystem zum Minimieren eines Bildnacheilens, wobei das Bilderzeugungssystem ein Pixelausgangssignal (PIXEL OUT) liefert und das Bilderzeugungssystem folgende Merkmale aufweist:

   eine Sensorlogik (12);

   einen Bildprozessor (14), der mit der Sensorlogik (12) verbunden ist und ein Gewinnsignal (GAIN) auf der Basis von Daten erzeugt, die von der Sensorlogik (12) empfangen werden;

   ein Pixelarray (18), das eine Mehrzahl von Pixelschaltungen (18n) aufweist, wobei jede Pixelschaltung (18n) einen Photodetektor (22), der zwischen eine Leistungsversorgung (PRESET) und Masse geschaltet und umgekehrt vorgespannt ist, und einen Pixelausgang aufweist, der mit einem Photodetektorknoten (PD) verbunden ist, der zwischen der Leistungsversorgung (PRESET) und dem Photodetektor (22) angeordnet ist; und

   eine Umkehrvorspannungssteuerung (16), die zwischen den Bildprozessor (14) und das Pixelarray (18) geschaltet ist und das Gewinnsignal (GAIN) von dem Bildprozessor (14) empfängt, wobei die Umkehrvorspannungssteuerung (16) ein Vorspannungssteuerungssignal (RESET) ansprechend auf das Gewinnsignal (GAIN) erzeugt, das von dem Bildprozessor (14) empfangen wird, und die Umkehrvorspannungssteuerung (16) das Vorspannungssteuerungssignal (RESET) zu dem Photoleiterknoten (PD) der Pixelschaltung (18n) des Pixelarrays (18) liefert, wodurch die Umkehrvorspannungsbedingung des Photodetektors (22) beibehalten wird.

2. Das Bilderzeugungssystem gemäß Anspruch 1, bei dem das Pixelarray (18) aus amorphem Silizium hergestellt ist.

3. Das Bilderzeugungssystem gemäß Anspruch 1 oder 2, bei dem die Umkehrvorspannungssteuerung (16) folgende Merkmale aufweist:

   eine Spannungsreferenztabelle (30), die das Gewinnsignal (GAIN) empfängt und eine Spannungsausgabe erzeugt; und

   einen Spannungsklemm-Digital-Analog-Wandler (32), der die Spannungsausgabe von der Spannungsreferenztabelle (30) empfängt und das Vorspannungssteuerungssignal (RESET) erzeugt.

4. Das Bilderzeugungssystem gemäß einem der Ansprüche 1 bis 3, bei dem jede Pixelschaltung (18n) des Pixelarrays (18) folgendes aufweist:

   einen ersten n-Kanal-Feldeffekttransistor (20), der ein Drain, das ein Zuführsignal (PRESET) empfängt, und ein Gate aufweist, das das Vorspannungssteuerungssignal (RESET) empfängt;

   einen zweiten n-Kanal-Feldeffekttransistor (24), der ein Drain, das mit einer Leistungszuführung (VDD) verbunden ist, und ein Gate aufweist, das mit der Source des ersten n-Kanal-Feldeffekttransistors (20) verbunden ist; und

   einen dritten n-Kanal-Feldeffekttransistor (26), der ein Drain, das mit der Source des zweiten n-Kanal-Feldeffekttransistors (24) verbunden ist, ein Gate, das mit dem Bildprozessor verbunden ist, und eine Source aufweist, die das Pixelausgangssignal (PIXEL OUT) liefert;

   wobei der Photodetektor (22) eine amorphe Siliziumdiode ist, die zwischen die Source des ersten n-Kanal-Feldeffekttransistors (20) und Masse geschaltet ist, wobei der Photodetektorknoten (PD) zwischen der Source des ersten n-Kanal-Feldeffekttransistors (20) und der amorphen Siliziumdiode (22) vorliegt.

**Revendications**

1. Système imageur pour minimiser un retard d'image, le système imageur fournissant un signal de pixel en sortie (PIXEL OUT) et le système imageur comprenant :

   ■ une logique de capture (12) ;

- un processeur d'images (14) connecté à la logique de capture (12) et engendrant un signal de gain (GAIN) sur la base de données reçues de la logique de capture (12) ;

- un arrangement de pixels (18) ayant une pluralité de circuits de pixel (18n), chaque circuit de pixel (18n) comprenant un photodétecteur (22) connecté et polarisé en inverse entre une alimentation (PRESET) et une masse et une sortie de pixel connectée à un noeud du photodétecteur (PD) arrangé entre l'alimentation (PRESET) et le photodétecteur (22) ; et

- un contrôleur de polarisation inverse (16) connecté entre le processeur d'images (14) et l'arrangement de pixels (18) et recevant le signal de gain (GAIN) issu du processeur d'images (14), le contrôleur de polarisation inverse (16) engendrant un signal pour commander la polarisation (RESET) en réponse au signal de gain (GAIN) reçu du processeur d'images (14) et le contrôleur de polarisation inverse (16) fournissant le signal pour commander la polarisation (RESET) au noeud du photoconducteur (PD) du circuit de pixel (18n) de l'arrangement de pixels (18), en maintenant ainsi la condition de polarisation inverse du photodétecteur (22).

2. Système imageur tel que défini dans la revendication 1, dans lequel l'arrangement de pixels (18) est fabriqué à partir de silicium amorphe.

3. Système imageur tel que défini dans la revendication 1 ou la revendication 2, dans lequel le contrôleur de polarisation inverse (16) inclut :

- une table de référence de tension (30), recevant le signal de gain (GAIN) et engendrant une sortie de tension ; et

- un convertisseur numérique/ analogique à pincement tension (32), recevant la sortie de tension issue de la table de référence de tension (30) et engendrant le signal pour commander la polarisation (RESET).

4. Système imageur tel que défini dans l'une quelconque des revendications 1 à 3, dans lequel chaque circuit de pixel (18n) de l'arrangement de pixels (18) comprend :

- un premier transistor à effet de champ à canal n (20) ayant un drain recevant une tension d'alimentation (PRESET) et une porte recevant le signal pour commander la polarisation (RESET) ;

- un deuxième transistor à effet de champ à canal n (24) ayant un drain connecté à une tension d'alimentation (VDD) et une porte connectée à la source du premier transistor à effet de champ à canal n (20) ; et

- un troisième transistor à effet de champ à canal n (26) ayant un drain connecté à la source du deuxième transistor à effet de champ à canal n (24), une porte connectée au processeur d'images et une source fournissant le signal de pixel en sortie (PIXEL OUT) ;

- dans lequel le photodétecteur (22) est une diode au silicium amorphe, connectée entre la source du premier transistor à effet de champ à canal n (20) et la masse, le noeud du photodétecteur (PD) étant entre la source du premier transistor à effet de champ à canal n (20) et la diode au silicium amorphe (22).

(PRIOR ART)

# FIG. 1

FIG.2

10

FIG.3

ROW EXPOSURE (INT1)

APS PIXEL

INT2= TRTF-INT1

ROW EXPOSURE (INT2)

2.2 VOLTS

0.5 VOLTS

0 OR -.2 VOLTS

TOTAL READ TIME FOR A FRAME (TRTF)= INT 1 INT 2

(VGA ARRAY WHERE INT2 > INT1 IN A VERY BRIGHT LIGHTING SCENE)

FIG.4

EP 1 195 987 B1

FIG.5

EP 1 195 987 B1

FIG.6

EP 1 195 987 B1

FIG.7

EP 1 195 987 B1